# FASCICULE DE BREVET EUROPEEN

(11) **EP 3 029 513 B1**
(45) Date de publication et mention de la délivrance du brevet: **10.10.2018**
(21) Numéro de dépôt: 15197034.0
(22) Date de dépôt: 30.11.2015
(51) Int. Cl.: G02F 1/025, G02F 1/225, G02B 6/134, G02B 6/136

(54) **PROCEDE DE FABRICATION D'UN GUIDE D'ONDE INCLUANT UNE JONCTION SEMICONDUCTRICE**
HERSTELLUNGSVERFAHREN EINES WELLENLEITERS, DER EINEN HALBLEITERANSCHLUSS UMFASST
METHOD FOR MANUFACTURING A WAVEGUIDE INCLUDING A SEMICONDUCTOR JUNCTION

(30) Priorité: 01.12.2014 FR 1461708
(43) Date de publication de la demande: 08.06.2016
(73) Titulaire: Commissariat à l'Énergie Atomique et aux Énergies Alternatives, 75015 Paris (FR)
(72) Inventeur: FOURNIER, Maryse, 38410 SAINT MARTIN D'URIAGE (FR); FOWLER, Daivid, 38950 SAINT MARTIN LE VINOUX (FR); GRELLIER, Edouard, 87220 Feytiat (FR); IOTTI, Lorenzo, 27020 Torre d'Isola (Pavia) (IT)
(74) Mandataire: Brevalex

(56) Documents cités:
- WO-A1-2014/103432
- GB-A- 2 477 131

## Description

### DOMAINE TECHNIQUE

L'invention se rapporte au domaine de la micro-électronique et de l'opto-électronique et concerne plus particulièrement les procédés de fabrication de structures semiconductrices pour l'optoélectronique intégrée, telles que les modulateurs optiques.

### ÉTAT DE LA TECHNIQUE ANTÉRIEURE

Les modulateurs optiques tels que les modulateurs du type Mach-Zehnder ou du type anneau résonnant, intègrent généralement un guide d'onde dont les propriétés optiques peuvent être modulées.

Un tel guide d'onde dont les propriétés optiques peuvent être modulées est généralement fourni par un guide d'onde semiconducteur dans lequel une jonction semiconductrice a préalablement été incluse. En effet, les propriétés optiques d'un tel guide d'onde, telles que l'indice effectif, peuvent être aisément modulées par une polarisation adéquate de la jonction semiconductrice.

Un procédé classique pour fabriquer un tel guide d'onde consiste à mettre en oeuvre les étapes suivantes :
- fourniture d'un support comportant une couche semiconductrice, au moins une première partie de la couche présentant un premier type de conductivité,
- implantation sélective d'éléments dopants d'un deuxième type de conductivité opposé au premier dans une deuxième partie de la couche semiconductrice adjacente à la première partie de manière à former une jonction semiconductrice entre les deux parties,
- gravure partielle de la couche de manière à former le guide d'onde, la gravure étant réalisée de manière à ce que la jonction semiconductrice soit incluse dans le guide d'onde.

Ces deux dernières étapes font toutes deux nécessairement appel à une procédure de masquage de la couche semiconductrice, ceci afin de positionner la zone d'implantation du deuxième type de conductivité et le guide d'onde lors de la gravure. Or, la jonction doit être positionnée au voisinage du centre du guide d'onde ce qui rend impossible une quelconque réutilisation des masques utilisés pendant l'implantation pour effectuer la gravure. Ainsi, la procédure de masquage pendant l'étape de gravure est nécessairement réalisée avec un alignement du masque de gravure par rapport à la jonction préalablement implantée.

Cet alignement, en raison du dimensionnement du guide d'onde et du fait que la jonction doit être précisément positionnée par rapport au centre du guide d'onde, est relativement complexe à mettre en place et augmente de manière drastique les coûts de fabrication d'un tel guide d'onde.

Le document US20130058606 A1 enseigne qu'il est possible, par une implantation de la jonction après formation du guide d'onde, d'utiliser le masquage utilisé pendant l'étape de gravure pour définir l'emplacement de la jonction.

Le procédé décrit dans ce document consiste ainsi à mettre en oeuvre les étapes principales suivantes :
- fourniture d'un support comportant une couche semiconductrice, au moins une première partie de la couche présentant un premier type de conductivité,
- gravure partielle de la couche de manière à former le guide d'onde dans la première partie de la couche,
- implantation sélective d'une deuxième partie de la couche semiconductrice restante après gravure, le guide d'onde étant protégé pendant l'implantation par le masque préalablement utilisé pendant la gravure de manière à ce que la deuxième partie implantée soit adjacente au guide.
- Traitement thermique pour activer les éléments dopants, ledit traitement engendrant une faible diffusion de la jonction à l'intérieur du guide d'onde.

Ainsi, la jonction formée est parfaitement positionnée par rapport au guide d'onde ceci sans avoir nécessité un alignement précis de masque. La fabrication d'un guide d'onde par un tel procédé présente donc un coût réduit avec une précision du positionnement de la jonction vis-à-vis du guide d'onde accrue.

Néanmoins, si un tel procédé permet un bon contrôle du positionnement de la jonction par rapport au guide d'onde sans augmentation drastique du coût de fabrication, la jonction se trouve forcément à proximité d'une paroi du guide d'onde et est donc à distance du centre du guide d'onde. Or, pour obtenir un fonctionnement optimisé du guide d'onde et une modulation de propriété optique maximale au centre du guide d'onde avec des pertes optiques limitées, il est nécessaire que la jonction soit positionnée à proximité du centre du guide d'onde. Il est à noter, de plus, que la diffusion des éléments dopants lors de l'étape d'activation ne permet pas d'obtenir une jonction verticale. En effet, la diffusion ayant lieu à partir du bord inférieur du guide d'onde, la jonction résultant de cette diffusion reste centrée par rapport à ce même bord. Le document WO2014103432 A1 divulgue un autre procédé de fabrication d'une jonction dans un guide.

### EXPOSÉ DE L'INVENTION

L'invention vise à résoudre cet inconvénient et a ainsi pour objet de permettre la fourniture d'un guide d'onde dont au moins une propriété optique puisse être modifiée, ceci sans nécessiter, pour fournir le guide d'onde avec un positionnement précis de la jonction à proximité du centre du guide d'onde, de surcoût notable lié à l'alignement de masque.

L'invention a en outre pour but de fournir un tel guide d'onde ceci avec une orientation de la jonction sensiblement transversale par rapport au plan du support dudit guide d'onde, ceci correspondant dans une configuration classique à une orientation verticale de la jonction.

L'invention concerne à cet effet un procédé de fabrication d'un guide d'onde incluant une jonction semiconductrice, ledit procédé comprenant les étapes suivantes :
- fourniture d'un support comportant une couche semiconductrice présentant au moins une première partie d'un premier type de conductivité comportant une concentration en éléments dopants du premier type de conductivité,
- protection de la première partie de la couche semiconductice,
- implantation sélective d'éléments dopants d'un deuxième type de conductivité opposé au premier type de conductivité dans une deuxième partie de la couche semiconductrice, la sélectivité de l'implantation étant obtenue au moyen de la protection de la première partie ceci de manière à ce que la deuxième partie soit adjacente de la première partie, l'implantation étant réalisée de manière à ce que la concentration en éléments dopants du deuxième type de conductivité dans la deuxième partie soit supérieure à celle en éléments dopants du premier type de conductivité dans la première partie,
- diffusion des éléments dopants du deuxième type de conductivité dans la première partie pour former une jonction semiconductrice dans la première partie,
- gravure partielle de la couche semiconductrice pour former le guide d'onde dans la première partie, la protection de la première partie étant utilisée lors de cette gravure pour délimiter une première paroi latérale du guide d'onde à l'interface entre la première et la deuxième partie de manière à ce que la jonction semiconductrice soit incluse dans le guide d'onde.

Avec un tel procédé, le positionnement de la jonction par rapport à la première paroi latérale du guide d'onde est déterminé par la longueur de diffusion des éléments dopants du deuxième type de conductivité dans la première partie. Ainsi, avec une diffusion adaptée des éléments dopants du deuxième type de conductivité, il est possible d'obtenir un positionnement de la jonction optimal par rapport à la première paroi et donc au centre du guide d'onde. Un tel procédé permet donc un positionnement de la jonction à proximité du centre du guide d'onde. De plus, la diffusion ayant lieu à partir de l'interface verticale entre la première et la deuxième partie, l'orientation finale de la jonction dans le guide d'onde est également verticale, c.-à-d. transversale vis-à-vis du support du guide d'onde.

Il est également à noter que le positionnement et l'orientation optimal de la jonction par rapport au centre du guide d'onde n'engendre pas de surcoût notable comme c'est le cas pour les procédés de l'art antérieur puisque l'alignement de masque pour la gravure est principalement obtenu par une réutilisation de la protection utilisée pendant l'implantation.

Il est à noter que bien entendu, si la couche semiconductrice présente une première partie du premier type de conductivité, cette caractéristique ne présage en rien le type de conductivité du reste de la couche semiconductrice. Ainsi, il est envisageable dans le cadre de l'invention que le reste de la couche semiconductrice soit tout ou partie du premier type de conductivité ou encore que le reste de la couche semiconductrice soit du deuxième type de conductivité ou encore de type intrinsèque.

Le procédé de fabrication étant un procédé de fabrication d'un guide d'onde de largeur W, la concentration en éléments dopants du deuxième type de conductivité implantés lors de l'étape d'implantation peut être adaptée pour que lors de l'étape de diffusion des éléments dopants du deuxième type de conductivité dans la première partie la diffusion ait lieu à partir de l'interface entre la première et la deuxième partie sur une distance comprise entre 10 et 70% de la largeur W, préférentiellement entre 30 et 50% de la largeur W.

Avec une telle adaptation de la concentration en éléments dopants du deuxième type de conductivité, un simple recuit pendant l'étape de diffusion permet de fournir un placement adéquat de la jonction pour son inclusion dans le guide d'onde. En effet, avec une telle concentration, les conditions de recuit, si elles sont suffisantes pour autoriser une diffusion maximale des éléments dopants, n'ont pas besoin d'être parfaitement contrôlées. C'est la concentration en éléments dopants dans la première et la deuxième partie de la couche semiconductrice qui définit la distance de diffusion.

Le rapport de la concentration en éléments dopants du deuxième type de conductivité implantés dans la deuxième partie sur celle en éléments dopants du premier type de conductivité dans la première partie peut être compris entre 2 et 30 et est préférentiellement compris entre 4 et 15.

Avec une implantation d'éléments dopants du deuxième type de conductivité pendant l'étape d'implantation, il est possible de fournir un placement de la jonction semiconductrice optimal par une étape de diffusion consistant en un simple recuit permettant de fournir une diffusion maximale des éléments dopants du deuxième type de conductivité.

Lors de la fourniture du support la zone de la couche qui est destinée à former la deuxième partie peut également être du premier type de conductivité et comporter une concentration en éléments dopants du premier type de conductivité sensiblement identique à celle de la première partie.

Lors de l'étape de protection de la première partie, il peut être déposé un premier masque qui protège la zone de la première partie destinée à former le guide d'onde pendant les étapes d'implantation et de gravure et il peut être également déposé un deuxième masque qui protège le reste de la première partie pendant l'implantation, le procédé comportant préalablement à l'étape de gravure une étape de suppression du deuxième masque.

L'utilisation de deux éléments de protection, un masque protégeant la zone de la première partie destinée à former le guide d'onde et un masque protégeant le reste de la première partie, permet une utilisation simplifiée de la protection pendant l'étape de gravure partielle. En effet, une suppression sélective du deuxième élément de protection permet d'obtenir une protection adéquate pour protéger la zone destinée à former le guide d'onde pendant l'étape de gravure partielle.

Le support peut être un support du type semiconducteur sur isolant, la couche semiconductrice étant la couche semiconductrice sur isolant du support.

Un tel support est particulièrement adapté pour fournir un guide d'onde de bonne qualité, la couche isolante participant au confinement de l'onde électromagnétique transitant dans le guide d'onde.

La couche semiconductrice peut être une couche de silicium.

Une telle couche est particulièrement adaptée pour l'obtention d'un guide d'onde présentant de bonnes caractéristiques optiques pour les ondes électromagnétique dans la gamme des infrarouges.

Les uns parmi les éléments dopants du premier et du deuxième type de conductivité peuvent être sélectionnés dans le groupe comportant du bore, de l'aluminium et de l'indium tandis que les autres parmi les éléments dopants du premier et du deuxième type de conductivité peuvent être sélectionnés dans le groupe comportant du phosphore, de l'arsenic et de l'antimoine, les éléments dopants du premier et du deuxième type de conductivité étant préférentiellement les uns du bore et les autres du phosphore.

L'étape de diffusion peut consister à appliquer un recuit thermique au support adapté pour obtenir une distance de diffusion des éléments du deuxième type de conductivité dans la première partie qui est maximale.

Ainsi, la distance de diffusion est parfaitement définie puisque cette distance est déterminée par la concentration en éléments dopants du deuxième type de conductivité implantés.

L'invention concerne en outre un procédé de fabrication d'un composant optoélectronique comportant un guide d'onde incluant une jonction semiconductrice, le procédé de fabrication comprenant les étapes de fabrication d'un guide d'onde selon l'invention.

Un tel procédé permet de bénéficier des avantages liés au procédé de fabrication d'un guide d'onde selon l'invention.

Le composant optoélectronique peut être un modulateur optique tel qu'un modulateur du type Mach-Zehnder ou du type anneau résonnant.

Un tel modulateur optique bénéficie particulièrement de la possibilité offerte par le procédé de fabrication d'un guide d'onde selon l'invention.

### BRÈVE DESCRIPTION DES DESSINS

La présente invention sera mieux comprise à la lecture de la description d'exemples de réalisation, donnés à titre purement indicatif et nullement limitatif, en faisant référence aux dessins annexés sur lesquels :
- les figures 1A à 1D illustrent les étapes de fabrication d'un guide d'onde selon le principe de l'invention, ledit guide d'onde incluant une jonction semiconductrice,
- la figure 2 est un graphique montrant le déplacement de la jonction en fonction de la concentration en éléments dopants implantés lors de l'étape d'implantation,
- les figures 3A à 3D illustrent respectivement et graphiquement la variation de la concentration en éléments dopants du premier et du deuxième type de conductivité le long d'une coupe transversale de quatre guide d'onde respectifs obtenus par implantation en éléments dopants du deuxième type de conductivité avec des concentrations différentes,
- les figures 4A à 4N illustrent les principales étapes de fabrications d'un composant semiconducteur, tel qu'un modulateur, comportant un guide d'onde selon l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

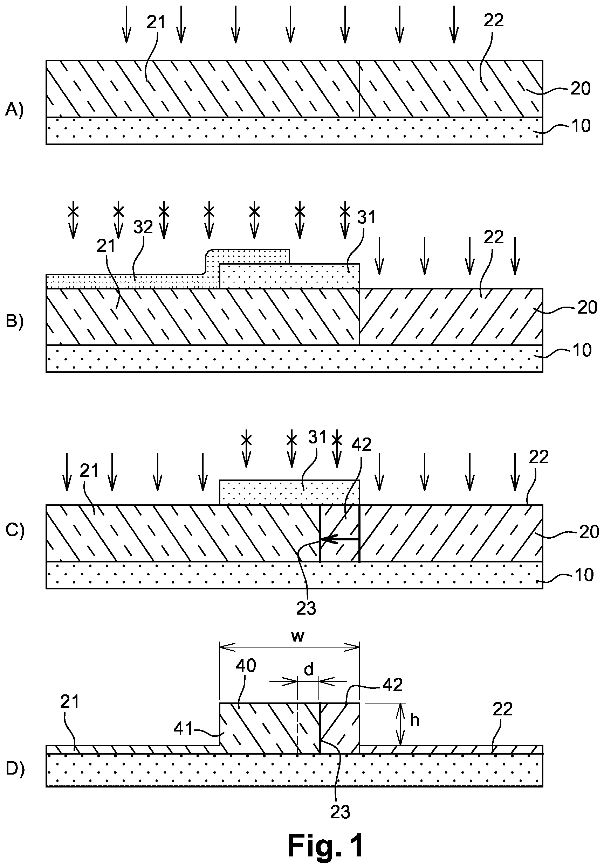

Les figures 1A à 1D illustrent les principales étapes de fabrication d'un guide d'onde 40 selon l'invention présentant des propriétés optiques modulables et qui est apte à être compris dans un composant tel qu'un modulateur optique du type Mach-Zehnder ou du type anneau.

Ainsi, selon le principe de l'invention illustré schématiquement et en coupe transversale sur la figure 1D, un composant 1 présentant un tel guide d'onde 40 comporte un support 10, tel qu'ici, un substrat de silicium sur lequel est disposé une couche d'isolant selon le principe de silicium sur isolant, plus connu sous son sigle anglais SOI, seule la couche isolante étant représentée.

Ledit support 10 comporte une couche semiconductrice 20 présentant une première partie 21 majoritairement d'un premier type de conductivité et une deuxième partie 22 d'un deuxième type de conductivité adjacente à la première partie 21, la première partie présentant à proximité de la deuxième partie 22 une portion du deuxième type de conductivité de manière à ce qu'une jonction semiconductrice 23 soit formée dans la première partie 21 à proximité de la deuxième partie 22.

Dans un but de simplification et à titre illustratif, dans la suite de cette description de l'invention le premier type de conductivité est défini comme le type de conductivité pour lequel les porteurs majoritaires sont des trous, celui étant dénommé par commodité « type P », tandis que le deuxième type de conductivité est défini comme le type de conductivité pour lequel les porteurs majoritaires sont des électrons, ce dernier étant dénommé par commodité « type N ». Ainsi, une portion présentant le premier et le deuxième type de conductivité sont respectivement dites dopée P et dopée N. Bien entendu, ce choix ne limite en rien la portée de l'invention, le premier et le deuxième type de conductivité pouvant être inversés sans sortir du cadre de l'invention.

La couche semiconductrice 20 comporte, comme illustré sur la figure 1D, le guide d'onde 40 aménagé dans celle-ci de manière à ce que la jonction 23 soit incluse dans le guide d'onde 40. Le guide d'onde est formé par une surépaisseur de la couche semiconductrice 20 qui fait saillie du reste de la couche semiconductrice 20 sur une hauteur h qui peut être comprise entre 100 et 500 nm. La largeur W du guide d'onde peut être comprise entre 100 et 500 nm. Le guide d'onde s'étend selon une direction qui est qualifiée de longitudinale en opposition à sa direction latérale selon laquelle est réalisée la coupe illustrée sur la figure 1D. Cette direction longitudinale peut, en fonction du composant équipé par le guide d'onde 40, être linéaire, curviligne et même formée un anneau.

Le guide d'onde 40 comporte, une première portion 41 de la première partie 21 dopée P et une deuxième portion 42 de la première partie 21 qui est la portion dopée N. L'interface entre la première et la deuxième portion 41, 42 du guide d'onde forme donc la jonction 23. La première et la deuxième portion 41, 42 et la jonction 23 sont longitudinales et s'étendent toutes trois selon la direction longitudinale du guide d'onde 40.

Selon la direction transversale, la jonction 23 est positionnée à une distance d du centre du guide d'onde 40. La distance d est comprise entre 0 et 45% de la largeur W du guide d'onde, soit 0 et 90% de la demi-largeur W/2.

Le procédé de fabrication d'un tel guide d'onde 40 comprend les étapes suivantes :
- fourniture, comme illustré sur la figure 1A, du support 10 comportant avec la couche semiconductrice 20 comprenant au moins une première partie 21 dopée P avec une première concentration en éléments dopants du type P,
- protection de la première partie 21 de la couche semiconductrice 20,
- implantation sélective, comme illustré sur la figure 1B, d'éléments dopants de type N dans une deuxième partie 22 de la couche semiconductrice 20, la sélectivité de l'implantation étant obtenue au moyen de la protection de la première partie 21 ceci de manière à ce que la deuxième partie 22 soit adjacente de la première partie 21, l'implantation étant réalisée de manière à ce que la concentration en éléments dopants du type N soit supérieure à celle en éléments dopants du type P dans la première partie 21,
- diffusion, comme illustré sur la figure 1C, des éléments dopants du type N dans la première partie 21 pour former une jonction 23 semiconductrice dans la première partie 21,
- gravure partielle, comme illustré sur la figure 1D, de la couche semiconductrice 20 pour former le guide d'onde 40 dans la première partie 21, la protection de la première partie 21 étant utilisée lors de cette gravure pour délimiter une première paroi latérale du guide d'onde 40 à l'interface entre la première et la deuxième partie 21, 22 de manière à ce que la jonction semiconductrice 23 soit incluse dans le guide d'onde.

Dans un exemple d'application pratique de l'invention, le support 10 est un support du type silicium sur isolant, la couche de silicium d'un tel support formant la couche semiconductrice 20. L'étape de fourniture du support 10 selon cet exemple comporte une première sous-étape de fourniture d'un support du type silicium sur isolant avec la couche de silicium superficielle non intentionnellement dopée.

Selon cette même application pratique, la formation de la première partie 21 de la couche semiconductrice 20 dopée P est réalisée par une sous-étape d'implantation de la couche semiconductrice 20 avec des éléments dopants du type P. Ces éléments dopants peuvent être du bore. L'implantation est réalisée par implantation ionique avec une dose de dopant de 1.10¹³ cm⁻² et une énergie d'implantation de 46 KeV. De cette manière, l'ensemble de la couche semiconductrice 20, dont sa première partie 21, est dopé P.

L'étape de protection de la première partie 21 peut être effectuée au moyen de deux masques différents 31, 32, un premier masque 31 protégeant la zone de la première partie 21 qui formera, après gravure, le guide d'onde 40, ce premier masque 31 étant, sur la figure 1B, un masque dur, et un deuxième masque 32, du type résine ou de tout type de matériau présentant une sélectivité de gravure par rapport au masque 31 et la couche semiconductrice 20, protégeant le reste de la première partie 21 qui est non protégée par le premier masque 31. Le premier masque 31 est dimensionné, pour l'exemple d'application pratique, pour former un guide d'onde 40 d'une largeur de 320 nm.

On peut voir sur la figure 1B, que le placement du deuxième masque 32 par rapport au premier masque 31 ne nécessite pas une opération d'alignement précise puisque la zone de recouvrement du deuxième masque 32 sur le premier masque 31 permet de compenser un éventuel désalignement du deuxième masque 32 par rapport au premier masque 31.

Le premier et le deuxième masque 31, 32 permettent de protéger la première partie 21 de la couche semiconductrice 20 pendant l'étape d'implantation de la deuxième partie 22.

Dans l'exemple d'application pratique, les éléments dopants du deuxième type de conductivité implanté est du phosphore. L'implantation est réalisée par implantation ionique avec une dose de dopant strictement supérieure à 1.10¹³ cm⁻², et inférieure ou égale à 1.10¹⁵ cm⁻², et une énergie d'implantation de 130 KeV. De cette manière l'implantation de la deuxième partie 22 est réalisée avec une concentration en éléments dopants supérieure à celle de la première partie 21 puisque l'on obtient une concentration de 7.10¹⁷ cm⁻³ dans la première partie 21, en dehors du guide d'onde, et de 7.10¹⁷ à 1.10¹⁹ cm⁻³ dans la deuxième partie 22.

Une telle différence de concentration en éléments dopants entre la première et la deuxième partie 21, 22 permet, avec les conditions du recuit de l'étape de diffusion, de définir la distance D selon laquelle les éléments dopants du type P diffuse dans la première partie 21. Une telle distance peut être qualifiée, pour simplifier, de distance de diffusion de la jonction.

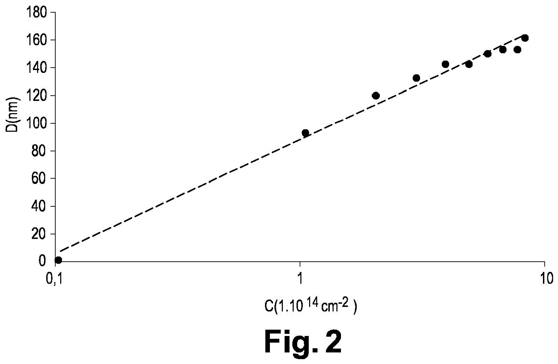

Ainsi la figure 2 illustre la distance D de diffusion de la jonction 23 en fonction de la dose C implantée d'éléments dopants du type N ceci dans le cadre de l'exemple d'application pratique. Ce graphique montre que pour une valeur de référence dans laquelle la dose d'éléments dopants dans la deuxième partie 22 est identique à celle de la première zone, c'est-à-dire égale à 1.10¹³ cm⁻², les éléments dopants du type N diffusent peu, voire pas. La distance de diffusion de la jonction pour cette dose est donc de 0 nm.

Lorsque la dose d'implantation en éléments dopants du type N devient supérieure à celle des éléments dopants du type P dans la première partie 21, le recuit permet d'obtenir une diffusion. Cette diffusion est d'autant plus importante que le rapport entre la dose en éléments dopants du type N sur celle du type P augmente. Cette diffusion variant de manière sensiblement logarithmique avec ce rapport, et donc avec la dose implantée de phosphore, comme illustré sur la figure 2.

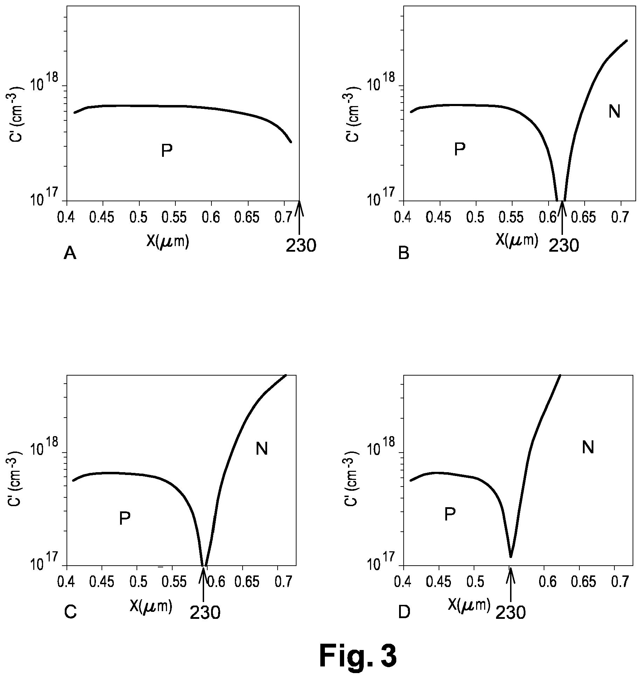

C'est cette variation qui est illustrée sur les figures 3A à 3D. En effet, les figure 3A à 3D représentent respectivement la variation de la concentration en éléments dopants C' le long d'une coupe transversale pour un guide d'onde après diffusion pour une implantation respective de 1.10¹³ cm⁻², 1,2.10¹⁴ cm⁻², 2,3.10¹⁴ cm⁻² et 1.10¹⁵ cm⁻² en phosphore dans la deuxième partie de la couche semiconductrice, et une dose de 1.10¹³ cm⁻² en bore dans la première partie 21. La jonction 23 est ainsi respectivement positionnée à 720 nm, 625 nm, 595 nm et 550 nm. Ces positions correspondent, sachant que les parois du guide d'onde sont respectivement positionnée à 720 et à 400 nm, à un positionnement respectif vis-à-vis du centre du guide d'onde de 100%, 46%, 21% et -6% de la demi-largeur W/2 du guide d'onde 40 selon l'exemple d'application particulière. Il est ainsi possible par une simple variation de la dose en éléments dopants implantés dans la deuxième partie 22 de définir le positionnement de la jonction par rapport au centre du guide d'onde.

Avec la configuration décrite dans l'exemple d'application, il peut être considéré qu'un positionnement d de la jonction par rapport au centre du guide d'onde 40 de 10% à 20% de la largeur du guide d'onde, soit 20% à 40% de la demi-largeur W/2, est optimal pour permettre une bonne modulation des caractéristiques optiques du guide d'onde 40 tout en limitant les pertes optiques. Un tel positionnement peut donc être obtenu, comme le montre les figures 3C et 3B, pour une dose de phosphore comprise entre 1,2.10¹⁴ cm⁻² et 2,3.10¹⁴ cm⁻² et une dose de bore de 1.10¹³ cm⁻². Ceci correspond à un facteur de l'ordre de 10 à 20 par rapport à la dose en bore qui a été implantée dans la première partie 21 de la couche semiconductrice 20, qui résulte en un rapport de concentration en éléments dopants dans la première et la deuxième partie 21, 22 avant diffusion de 4 à 6. On notera qu'un positionnement d de la jonction par rapport au centre du guide d'onde 40 de 20% de la demi-largeur du guide d'onde est à préférer, et donc qu'un facteur 10 par rapport à la dose en bore est avantageux pour la dose en phosphore. Un tel rapport de dose correspond à un rapport en concentration en éléments dopants dans la première et la deuxième partie 21, 22 avant diffusion de 4.

Après implantation de la deuxième partie 22 de la couche semiconductrice 20, l'étape de diffusion peut être réalisée au moyen d'un recuit de l'ensemble support 10/couche semiconductrice 20 à 1050°C pendant 10s. Un tel recuit est suffisant pour que la distance de diffusion des éléments dopants de type N dans la première partie 21 soit maximale. On obtient donc ainsi une diffusion de la jonction 23 également maximale dans la première partie 21 de la couche semiconductrice 20, la jonction 23 étant alors positionnée dans la première partie 21 de la couche semiconductrice 20.

L'étape de gravure partielle, telle qu'elle est illustrée sur la figure 1D, comporte les sous-étapes suivantes :
- suppression du deuxième masque 32 de manière à ne laisser protégée que la zone de la première partie 21 se trouvant sous le premier masque 31 et qui est destinée à être incluse dans le guide d'onde 40, la jonction 23 se trouvant dans la zone protégée par le premier masque 31,
- gravure des zones non protégées de la couche semiconductrice 20 sur une hauteur h de manière à former le guide d'onde 40,
- suppression du premier masque 31.

La sous étape de gravure peut être aussi bien réalisée en voie humique, telle que par une gravure au moyen d'un acide, ou en voie sèche telle que par une gravure ionique réactive. De plus, la zone de la couche semiconductrice destinée à former le guide d'onde étant protégée par le premier masque 31, la protection de la première partie est donc utilisée lors de la gravure pour notamment délimiter une première paroi latérale du guide d'onde 40 à l'interface entre la première et la deuxième partie 21, 22.

Ainsi, la jonction 23 étant incluse dans la zone de la couche semiconductrice 20 protégée par le premier masque 31, elle se retrouve incluse dans le guide d'onde 40. De plus, l'emplacement des parois du guide d'onde est défini par le premier masque 31 avec l'une d'elle qui correspond à l'interface entre la première et la deuxième partie 21,22. Il en résulte que le positionnement de la jonction 23 défini par la diffusion des éléments dopants de type N à partir de l'interface entre la première et la deuxième partie 21,22, et également défini par rapport à la paroi du guide d'onde 40 correspondant à cette même interface.

Le positionnement de la jonction 23 dans le guide d'onde 40 est donc parfaitement défini sans avoir nécessité de lourde étape d'alignement de masque.

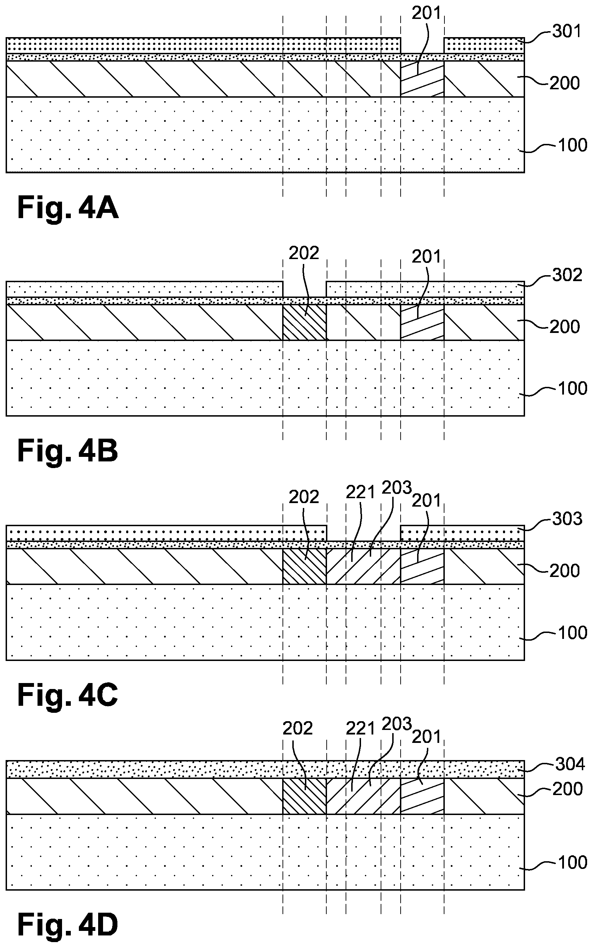

Un tel procédé peut être mis en oeuvre dans le cadre la fabrication d'un composant optoélectronique tel qu'un modulateur optique qu'il soit du type Mach-Zehnder ou du type anneau résonnant. Les figures 4A à 4N illustrent justement l'intégration d'un procédé de fabrication d'un guide d'onde selon l'invention dans le cadre de la fabrication d'un composant optoélectronique 1 incluant un tel guide d'onde. Ce composant incluant un modulateur optique tel qu'un modulateur optique type Mach-Zehnder ou anneau résonnant.

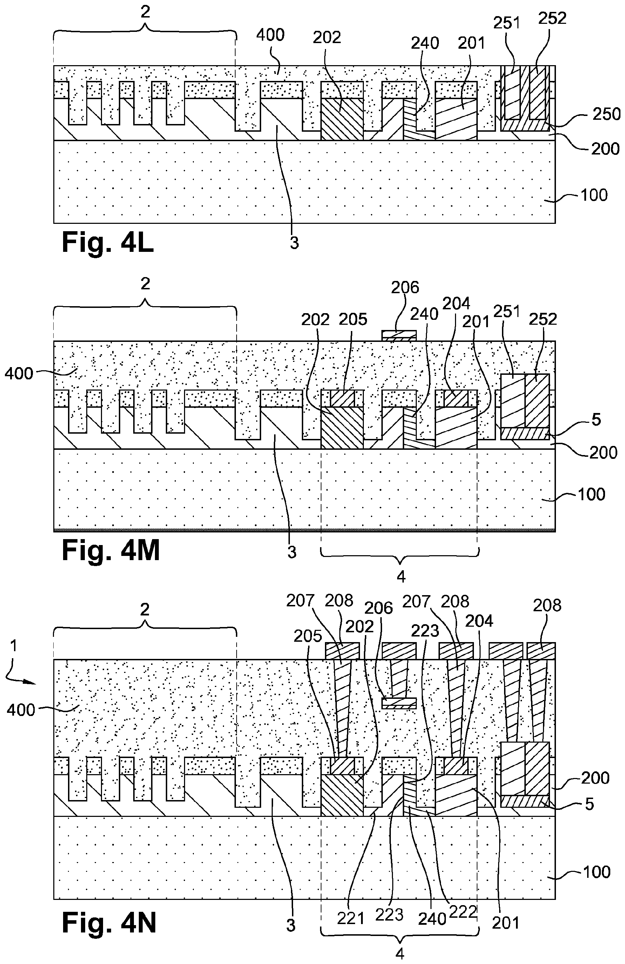

Ledit composant 1 comporte, comme illustré sur la figure 4N :
- un réseau de couplage 2 adapté pour recevoir un rayonnement électromagnétique à une longueur d'onde donnée,
- un premier guide d'onde 3,
- un deuxième guide d'onde 4, ledit deuxième guide d'onde 4 étant un guide d'onde selon l'invention et qui comporte donc une jonction 223, ledit deuxième guide d'onde 4 comportant en outre des contacts 204, 205 pour permettre une polarisation de sa jonction 223 et un élément résistif 206 formant système de chauffage pour permettre de compenser les variations de température qui pourrait engendrer un décalage de sa réponse optique,
- une photodiode 5 adaptée pour recevoir un rayonnement.

Il est à noter que si les figures 4A à 4N illustrent des vues en coupe transversale, ces différents éléments du composant illustré figure 4N sont bien entendu en trois dimensions et présentent donc de ce fait des connexions entre eux non présentes dans le plan de coupe.

Ainsi, dans le cas où le modulateur optique est du type Mach-Zehnder, le réseau de couplage 2 est connecté optiquement au premier et au deuxième guide d'onde 3, 4 de manière à ce que ces derniers forment chacun l'une des branches d'un modulateur optique du type Mach-Zehnder, la sortie du modulateur ainsi formé étant elle-même connectée optiquement à la photodiode 5.

Dans le cas où le modulateur est du type anneau résonnant, le réseau de couplage 2 est connecté optiquement au premier guide d'onde 3, ce dernier étant couplé optiquement au deuxième guide d'onde 4 qui forme un anneau résonnant. La sortie du premier guide d'onde, donc celle du modulateur optique, étant connectée optiquement à la photodiode 5.

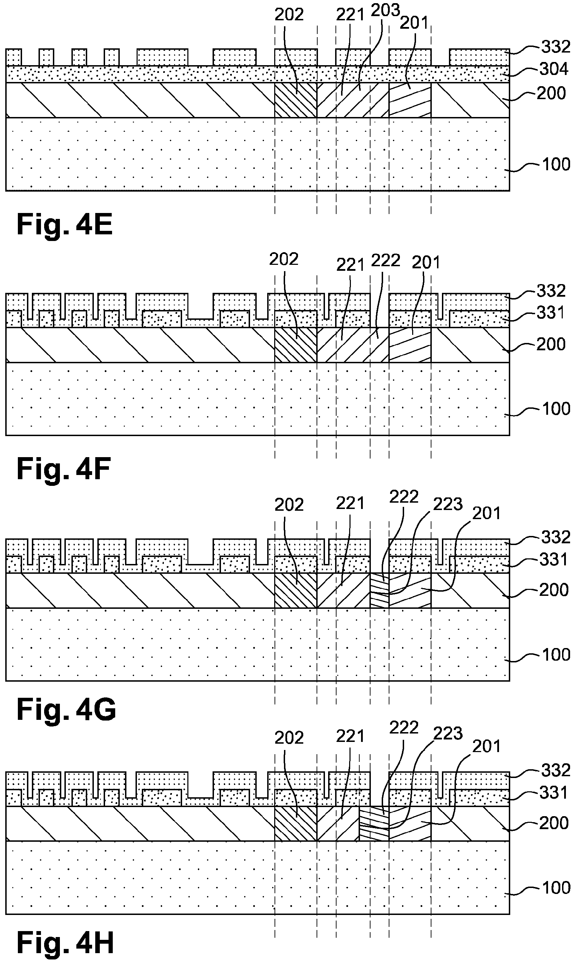

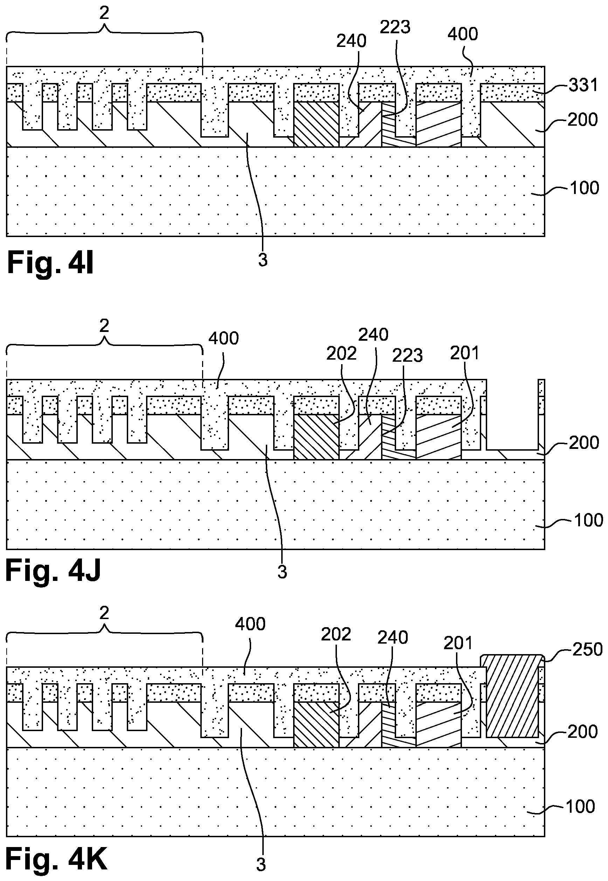

Un procédé de fabrication d'un tel composant comporte les étapes suivantes :
- fourniture d'un support 100 semiconducteur du type SOI, la couche semiconductrice 200 comportant à sa surface un écran de dioxyde de silicium,
- dépôt d'un masque 301 ledit masque comportant une ouverture pour la formation d'une première zone 201 dopée P dans la couche semiconductrice 200,
- implantation en éléments dopants de type P dans la zone 201 de la couche semiconductrice non protégée, tel qu'illustré sur la figure 4A,
- suppression du masque 301 et dépôt d'un autre masque 302, ledit autre masque 302 comportant une ouverture pour la formation d'une deuxième zone 202 dopée N,
- implantation en éléments dopants de type N dans la zone 202 de la couche semiconductrice 200 non protégée par le masque 302, tel qu'illustré sur la figure 4B,
- suppression du masque 302 et dépôt d'un autre masque 303 de manière à permettre le dépôt sur une zone 203 de la couche semiconductrice 200 comprise entre les zones 201, 202 préalablement implantées, ladite zone 203 comprenant une première partie 221 de la couche semiconductrice 200,
- implantation en éléments dopants de type P dans la zone 203 de la couche semiconductrice non protégée par le masque 302, ladite zone 203 comportant la première partie 221 de la couche semiconductrice 200, tel qu'illustré sur la figure 4C,
- suppression du masque 303 et dépôt d'une couche 304 apte à former un premier masque dur, tel qu'illustré sur la figure 4D,
- dépôt d'un deuxième masque 332 sur la couche apte à former un premier masque 331 dur, ce deuxième masque 332 comportant des ouvertures afin de graver la couche 304 pour former le premier masque 331, tel qu'illustré sur la figure 4E,
- gravure sélective de la couche 304 apte à former le premier masque 331 au travers du deuxième masque 332 de manière à reporter les ouvertures du deuxième masque 332 dans ladite couche 304 et ainsi former le premier masque 331,
- ajout de portion supplémentaire du matériau formant le deuxième masque 332 de manière à compléter le deuxième masque 332, cet ajout étant réalisé de manière à protéger la première partie 221 de la couche semiconductrice 200 et de manière à laisser libre une deuxième partie 222 de la couche semiconductrice 200, comme cela est illustré sur la figure 4F, une telle étape consiste ainsi en une protection de la première partie 221 de la couche semiconductrice 200,
- implantation sélective d'éléments dopants du type N dans la deuxième partie 222 de la couche semiconductrice 200, la sélectivité de l'implantation étant obtenue au moyen du premier et deuxième masque 331, 332, l'implantation étant réalisée de manière à ce que la concentration en éléments dopants du type N dans la deuxième partie 222 est supérieure à celle en éléments dopants du type P dans la première partie 221, tel qu'illustré sur la figure 4G,
- diffusion des éléments dopants du type N dans la première partie 221 pour former une jonction semiconductrice 223 dans la première partie 221, tel qu'illustré sur la figure 4H,
- suppression du deuxième masque 332,
- gravure partielle de la couche semiconductrice 200 sur une hauteur h au travers du premier masque 331 ceci afin de reporter les ouvertures du premier masque 331 sur la couche semiconductrice 200, ladite gravure sélective permettant la formation du réseau de couplage 2, du premier guide d'onde 3 et de la partie fonctionnelle 240 deuxième guide d'onde 4, cette dernière étant formée dans la première partie 221, le premier masque 331 étant utilisé pour délimiter une première paroi latérale du guide d'onde 4 à l'interface entre la première et la deuxième partie 221, 222 de manière à ce que la jonction semiconductrice 223 soit incluse dans le guide d'onde 4,
- dépôt d'une couche d'isolant 400, tel qu'illustré sur la figure 4I,
- gravure partielle de la couche d'isolant 400 et de la couche semiconductrice 220 au niveau d'une zone de la couche semiconductrice adjacente à la partie fonctionnelle 240 du deuxième guide d'onde 4 et qui est opposée au réseau de couplage 2, comme cela est illustré par la figure 4J,
- dépôt de germanium dans l'espace libéré lors de la gravure partielle de manière à former une portion 250 de germanium, comme illustré sur la figure 4K,
- implantation d'éléments dopants respectivement du type P et du type N dans une première et deuxième zone 251, 252 de la portion de germanium 250 déposée, tel qu'illustré sur la figure 4L,
- diffusion des éléments dopants dans la portion de germanium 250 de manière à former une jonction semiconductrice et obtenir la photodiode 5,
- dépôt d'un contact électrique 204, 205 sur chacune des zones adjacentes 201, 202 du guide d'onde 240 de manière à permettre une polarisation de la jonction 223 incluse dans le guide d'onde au moyen de ces deux contacts électriques 204, 205,
- dépôt d'une couche d'isolant,
- dépôt d'un élément résistif 206 en surplomb du guide d'onde, ledit élément résistif 205 étant agencé pour transmettre de la chaleur au guide d'onde lorsqu'il est parcouru de courant de manière à permettre de compenser les variations thermiques qui pourrait engendrer un décalage de la réponse optique du guide d'onde, tel qu'illustré sur la figure 4M,
- gravure sélective de la couche d'isolant 400 de manière à former des passages pour des interconnexions verticales afin de connecter les contacts 204, 205 électriques des zones adjacentes 201, 202 du guide d'onde, l'élément résistif et les deux pôles de la photodiode germanium,
- remplissage des passages formés dans la couche isolante 400 de manière à constituer des interconnexions verticales 207 pour connecter les zones adjacente 201, 202 du guide d'onde, l'élément résistif 206 et les deux pôles de la photodiode germanium 5,
- formation de contacts surfaciques 208 sur les interconnexions verticales 207, tel qu'illustré sur la figure 4N.

Un composant 1 tel qu'obtenu par un tel procédé, donné à titre d'exemple d'intégration d'un guide d'onde selon l'invention, permet de recevoir une onde électromagnétique sur le réseau de couplage 2, de faire transiter cette onde électromagnétique dans les deux guides d'onde 3, 4 avec possibilité de la moduler au moyen d'une polarisation adéquate du deuxième guide d'onde 4 et de mesurer l'onde ainsi modulée au moyen de la photodiode germanium 5. Ceci démontre qu'un procédé de fabrication d'un guide d'onde 4 selon l'invention peut aisément être intégré à un procédé de fabrication d'un composant optoélectronique plus complexe tel qu'un modulateur optique.

Si selon le mode de réalisation décrit ci-dessus, le support peut être un support du type SOI avec la couche semiconductrice qui est une couche de silicium sur isolant du type intrinsèque, le support et la couche semiconductrice qu'il comporte peuvent être d'un autre type sans que l'on sorte du cadre de l'invention. Ainsi, le support peut aisément comporter une couche semiconductrice d'un autre type, tel que du germanium, du Carbure de Silicium ou du phosphore d'indium. Bien entendu, les éléments dopant du premier et du deuxième type de conductivité sont à adapter en fonction du matériau semiconducteur constituant la couche semiconductrice. De telles adaptations étant connues de l'homme du métier, ce dernier est à même de transposer le procédé selon l'invention à ces matériaux semiconducteurs aux moyens de simples essais de routine.

Ainsi, si on prend le seul exemple du silicium, les éléments dopants du premier et du deuxième type de conductivité peuvent être sélectionnés dans le groupe comportant du bore, de l'aluminium et de l'indium tandis que les autres parmi les éléments dopants du premier et du deuxième type de conductivité sont sélectionnés dans le groupe comportant du phosphore, de l'arsenic et de l'antimoine. Ces alternatives au bore et au phosphore sont usuelles et l'homme du métier est parfaitement à même, à partir de l'enseignement ce document et de ces connaissances générales, d'adapter le procédé selon l'invention à ces différents éléments dopants.

## Revendications

1. Procédé de fabrication d'un guide d'onde (40, 240) incluant une jonction semiconductrice (23, 223), ledit procédé comprenant les étapes suivantes :
- fourniture d'un support (10, 100) comportant une couche semiconductrice (20, 200) présentant au moins une première partie (21, 221) d'un premier type de conductivité comportant une concentration en éléments dopants du premier type de conductivité,
- protection de la première partie (21, 221) de la couche semiconductrice (20, 200),
- implantation sélective d'éléments dopants d'un deuxième type de conductivité opposé au premier type de conductivité dans une deuxième partie (22, 222) de la couche semiconductrice (20, 200), la sélectivité de l'implantation étant obtenue au moyen de la protection de la première partie (21, 221) ceci de manière à ce que la deuxième partie (22, 222) soit adjacente de la première partie (21, 221), l'implantation étant réalisée de manière à ce que la concentration en éléments dopants du deuxième type de conductivité dans la deuxième partie (22, 222) soit supérieure à celle en éléments dopants du premier type de conductivité dans la première partie (21, 221),
- diffusion des éléments dopants du deuxième type de conductivité dans la première partie (21, 221) pour former une jonction semiconductrice (23, 223) dans la première partie (21, 221),
- après que les étapes d'implantation et de diffusion aient été effectuées, gravure partielle de la couche semiconductrice (20, 200) pour former le guide d'onde (40, 240) dans la première partie (21, 221), la protection de la première partie (21, 221) étant utilisée lors de cette gravure pour délimiter une première paroi latérale du guide d'onde (40, 240) à l'interface entre la première et la deuxième partie (21, 221, 22, 222) de manière à ce que la jonction semiconductrice (23, 223) soit incluse dans le guide d'onde (40, 240).

2. Procédé de fabrication selon la revendication 1 d'un guide d'onde (40, 240) de largeur W, dans lequel la concentration en éléments dopants du deuxième type de conductivité implantés lors de l'étape d'implantation est adaptée pour que lors de l'étape de diffusion des éléments dopants du deuxième type de conductivité dans la première partie (21, 221) la diffusion ait lieu à partir de l'interface entre la première et la deuxième partie (21, 221, 22, 222) sur une distance comprise entre 10 et 70% de la largeur W, préférentiellement entre 30 et 50% de la largeur W.

3. Procédé de fabrication selon la revendication 2 dans lequel le rapport de la concentration en éléments dopants du deuxième type de conductivité implantés dans la deuxième partie (22, 222) sur celle en éléments dopants du premier type de conductivité dans la première partie (21, 221) est compris entre 2 et 30 et est préférentiellement compris entre 4 et 15.

4. Procédé de fabrication selon l'une quelconque des revendication 1 à 3, dans lequel lors de la fourniture du support (10,11) la zone de la couche qui est destinée à former la deuxième partie est également du premier type de conductivité et comporte une concentration en éléments dopants du premier type de conductivité sensiblement identique à celle de la première partie (21, 221).

5. Procédé de fabrication selon l'une quelconque des revendications 1 à 4, dans laquelle lors de l'étape de protection de la première partie (21, 221), il est déposé un premier masque (31, 331) qui protège la zone de la première partie (21, 221) destinée à former le guide d'onde (40, 240) pendant les étapes d'implantation et de gravure et il est également déposé un deuxième masque (32, 332) qui protège le reste de la première partie (21, 221) pendant l'implantation, le procédé comportant préalablement à l'étape de gravure une étape de suppression du deuxième masque (32, 332).

6. Procédé de fabrication selon l'une quelconque des revendications 1 à 5, dans lequel le support (10, 100) est un support du type semiconducteur sur isolant, la couche semiconductrice (20, 200) étant la couche semiconductrice sur isolant du support (10,100).

7. Procédé de fabrication selon l'une quelconque des revendications 1 à 6, dans lequel la couche semiconductrice (20, 200) est une couche de silicium.

8. Procédé de fabrication selon la revendication 7, dans lequel les uns parmi les éléments dopants du premier et du deuxième type de conductivité sont sélectionnés dans le groupe comportant du bore, de l'aluminium et de l'indium tandis que les autres parmi les éléments dopants du premier et du deuxième type de conductivité sont sélectionnés dans le groupe comportant du phosphore, de l'arsenic et de l'antimoine, les éléments dopants du premier et du deuxième type de conductivité étant préférentiellement pour les uns du bore et pour les autres du phosphore.

9. Procédé de fabrication d'un composant (1) optoélectronique comportant un guide d'onde (240) incluant une jonction semiconductrice (223), le procédé de fabrication comprenant les étapes de fabrication d'un guide d'onde (240) selon l'une quelconque des revendication 1 à 8.

10. Procédé de fabrication selon la revendication 9, dans lequel le composant (1) optoélectronique comporte un modulateur optique tel qu'un modulateur du type Mach-Zehnder ou du type anneau résonnant.

## Patentansprüche

1. Verfahren zum Herstellen eines Wellenleiters (40, 240), welcher einen Halbleiterübergang (23, 223) umfasst, wobei das Verfahren die folgenden Schritte umfasst:
- Bereitstellen eines Trägers (10, 100), welcher eine Halbleiterschicht (20, 200) umfasst, welche wenigstens einen ersten Abschnitt (21, 221) mit einem ersten Leitfähigkeitstyp aufweist, welcher eine Konzentration von Dotierungselementen des ersten Leitfähigkeitstyps umfasst,
- Schützen des ersten Abschnitts (21, 221) der Halbleiterschicht (20, 200),
- selektives Implantieren von Dotierungselementen von einem zweiten Leitfähigkeitstyp, welcher dem ersten Leitfähigkeitstyp entgegengesetzt ist, in einem zweiten Abschnitt (22, 222) der Halbleiterschicht (20, 200), wobei die Selektivität der Implantierung mittels des Schutzes des ersten Abschnitts (21, 221) derart erhalten wird, dass der zweite Abschnitt (22, 222) dem ersten Abschnitt (21, 221) benachbart ist, wobei die Implantierung derart durchgeführt wird, dass die Konzentration an Dotierungselementen des zweiten Leitfähigkeitstyps in dem zweiten Abschnitt (22, 222) größer ist als diejenige an Dotierungselementen des ersten Leitfähigkeitstyps in dem ersten Abschnitt (21, 221),
- Diffundieren der Dotierungselemente des zweiten Leitfähigkeitstyps in den ersten Abschnitt (21, 221), um einen Halbleiterübergang (23, 223) in dem ersten Abschnitt (21, 221) zu bilden,
- nachdem die Schritte des Implantierens und des Diffundierens durchgeführt worden sind, teilweises Ätzen der Halbleitschicht (20, 200), um den Wellenleiter (40, 240) in dem ersten Abschnitt (21, 221) zu bilden, wobei der Schutz des ersten Abschnitts (21, 221) während des Ätzens verwendet wird, um eine erste laterale Wand des Wellenleiters (40, 240) an der Schnittstelle zwischen dem ersten und dem zweiten Abschnitt (21, 221, 22, 222) derart zu begrenzen, dass der Halbleiterübergang (23, 223) in dem Wellenleiter (40, 240) enthalten ist.

2. Verfahren zum Herstellen nach Anspruch 1 eines Wellenleiters (40, 240) der Breite W, wobei die Konzentration an Dotierungselementen des zweiten Leitfähigkeitstyps, die während des Schritts des Implantierens implantiert werden, derart angepasst ist, dass während des Schritts des Diffundierens der Dotierungselemente des zweiten Leitfähigkeitstyps in den ersten Abschnitt (21, 221) die Diffusion ausgehend von der Schnittstelle zwischen dem ersten und dem zweiten Abschnitt (21, 221, 22, 222) über eine Distanz stattfindet, welche zwischen 10 und 70% der Breite W beträgt, vorzugsweise zwischen 30 und 50% der Breite W.

3. Verfahren zum Herstellen nach Anspruch 2, wobei das Verhältnis zwischen der Konzentration an Dotierungselementen vom zweiten Leitfähigkeitstyp, welche in den zweiten Abschnitt (22, 222) implantiert werden, zu derjenigen an Dotierungselementen des ersten Leitfähigkeitstyps in dem ersten Abschnitt (21, 221) zwischen 2 und 30 und vorzugsweise zwischen 4 und 15 beträgt.

4. Verfahren zum Herstellen nach einem der Ansprüche 1 bis 3, wobei während des Bereitstellens des Trägers (10, 11) die Zone der Schicht, welche dazu vorgesehen ist, den zweiten Abschnitt zu bilden, ebenfalls von dem ersten Leitfähigkeitstyp ist und eine Konzentration an Dotierungselementen vom ersten Leitfähigkeitstyp umfasst, welche im Wesentlichen identisch zu derjenigen des ersten Abschnitts (21, 221) ist.

5. Verfahren zum Herstellen nach einem der Ansprüche 1 bis 4, wobei während des Schritts des Schützens des ersten Abschnitts (21, 221) eine erste Maske (31, 331) angelagert wird, welche die Zone des ersten Abschnitts (21, 221) schützt, welche dazu vorgesehen ist, den Wellenleiter (40, 240) während der Schritte des Implantierens und des Ätzens zu bilden, und wobei ebenfalls eine zweite Maske (32, 332) angelagert wird, welche den Rest des ersten Abschnitts (21, 221) während des Implantierens schützt, wobei das Verfahren vorzugsweise beim Schritt des Ätzens einen Schritt eines Entfernens der zweiten Maske (32, 332) umfasst.

6. Verfahren zum Herstellen nach einem der Ansprüche 1 bis 5, wobei der Träger (10, 100) ein Träger vom Halbleiter-auf-Isolator-Typ ist, wobei die Halbleiterschicht (20, 200) die Halbleiterschicht auf dem Isolator des Trägers (10, 100) ist.

7. Verfahren zum Herstellen nach einem der Ansprüche 1 bis 6, wobei die Haltleiterschicht (20, 200) eine Siliziumschicht ist.

8. Verfahren zum Herstellen nach Anspruch 7, wobei die einen aus den Dotierungselementen des ersten und des zweiten Leitfähigkeitstyps aus der Gruppe ausgewählt sind, umfassend, Bor, Aluminium und Indium, während die anderen aus den Dotierungselementen des ersten und zweiten Leitfähigkeitstyps ausgewählt sind aus der Gruppe, umfassend Phosphor, Arsen und Antimon, wobei die Dotierungselemente des ersten und des zweiten Leitfähigkeitstyps vorzugsweise die einen Bor und die anderen Phosphor sind.

9. Verfahren zum Herstellen einer optoelektronischen Baugruppe (1), umfassend einen Wellenleiter (240), welcher einen Halbleiterübergang (223) umfasst, wobei das Verfahren zur Herstellung die Schritte einer Herstellung eines Wellenleiters (240) nach einem der Ansprüche 1 bis 8 umfasst.

10. Verfahren zum Herstellen nach Anspruch 9, wobei die optoelektronische Baugruppe (1) einen optischen Modulator umfasst, wie beispielsweise einen Modulator vom Mach-Zehnder-Typ oder vom Resonanzring-Typ.

## Claims

1. A method for manufacturing a waveguide (40, 240) including a semiconducting junction (23, 223), the method comprising:
- providing a support (10, 100) comprising a semiconducting layer (20, 200) having at least one first part (21, 221) of a first conductivity type comprising a concentration of first conductivity-type dopants,
- protecting the first part (21, 221) of the semiconducting layer (20, 200),
- selectively implanting dopants of a second conductivity type opposite to the first conductivity type in a second part (22, 222) of the semiconducting layer (20, 200), the implantation selectivity being achieved by means of the protection of the first part (21, 221) so that the second part (22, 222) is adjacent to the first part (21, 221), the implantation being made so that the concentration of second conductivity-type dopants in the second part (22, 222) is greater than the one of the first conductivity-type dopants in the first part (21, 221),
- diffusing the dopants of the second conductivity type in the first part (21, 221) to form a semiconducting junction (23, 223) in the first part (21, 221),
- after the steps of implanting and diffusing have been performed, partially etching the semiconducting layer (20, 200) to form the waveguide (40, 240) in the first part (21, 221), the protection of the first part (21, 221) being used during this etching to bound the first side wall of the waveguide (40, 240) at the interface between the first and the second parts (21, 221, 22, 222) so that the semiconducting junction (23, 223) is included in the waveguide (40, 240).

2. The manufacturing method according to claim 1 of a waveguide (40, 240) of a width W, wherein the concentration of the dopants of the second conductivity type implanted during the implanting step is adapted so that during diffusing the dopants of the second conductivity type in the first part (21, 221), diffusion occurs from the interface between the first and the second parts (21, 221, 22, 222) over a distance between 10 and 70% of the width W, preferably between 30% and 50 % of the width W.

3. The manufacturing method according to claim 2, wherein the ratio of the concentration of the dopants of the second conductivity type dopants implanted in the second part (22, 222) to the dopants of the first conductivity type dopants in the first part (21, 221) is between 2 and 30 and is preferably between 4 and 15.

4. The manufacturing method according to any one from claims 1 to 3, wherein during providing the support (10, 11) the area of the layer which is intended to form the second part is also of the first conductivity type and includes a concentration of the dopants of the first conductivity type substantially identical to the one of the first part (21, 221).

5. The manufacturing method according to any one from claims 1 to 4, wherein during the protecting the first part (21, 221), a first mask (31, 331) is deposited which protects the area of the first part (21, 221) intended to form the waveguide (40, 240) during the steps of implanting and etching and a second mask (32, 332) is also deposited which protects the remainder of the first part (21, 221) during implanting, the manufacturing method comprising prior to the etching a removing the second mask (32, 332).

6. The manufacturing method according to any one from claim 1 to 5, wherein the support (10, 100) is a semiconductor-on-insulator-type support, the semiconducting layer (20, 200) being the semiconductor layer on insulator of the support (10,100).

7. The manufacturing method according to any one from claims 1 to 6, wherein the semiconducting layer (20, 200) is a silicon layer.

8. The manufacturing method according to claim 7, wherein the ones among the first and second conductivity-type dopants are selected from the group comprising boron, aluminium and indium whereas the others among the first and second conductivity-type dopants are selected from the group including phosphorus, arsenic and antimony, wherein preferably the ones among the first and second conductivity-type dopants are boron and the others among the first and second conductivity-type dopants are phosphorus.

9. A method for manufacturing an optoelectronic component (1) having a waveguide including a semiconducting junction (240), the manufacturing method comprising the steps of manufacturing a waveguide according to any one from claims 1 to 8.

10. The manufacturing method according to claim 9, wherein the optoelectronic component (1) includes an optical modulator such as a Mach-Zehnder-type or resonant ring-type modulator.
